# EUROPEAN PATENT APPLICATION

(11) **EP 4 586 454 A1**
(43) Date of publication of application: **16.07.2025**
(21) Application number: 24212746.2
(22) Date of filing: 13.11.2024
(51) Int. Cl.: H02J 7/00

(54) **METHOD AND APPARATUS FOR PROTECTING PRECHARGE RESISTOR PROVIDED IN BATTERY PACK**

(30) Priority: 11.01.2024 KR 20240004860
(71) Applicant: SAMSUNG SDI CO., LTD., Yongin-si, Gyeonggi-do 17084 (KR)
(72) Inventor: Park, Dongjin, 17113 Yongin-si, Gyeonggi-do (KR)
(74) Representative: Gulde & Partner

(57) **Abstract**

A method of protecting a precharge resistor provided in a battery pack, including attempting a first attempt to charge a precharge capacitor, the precharge capacitor being electrically connected to two ends of a battery module provided in the battery pack and charged by receiving a precharge current from the battery module, adding predetermined penalty points to a summed penalty point total based on a result of the first attempt to charge the precharge capacitor determining whether the precharge resistor is in a limited state based on the summed penalty point total, and preventing a second attempt to charge the precharge capacitor for a predetermined time if the precharge resistor is in the limited state.

## Description

### BACKGROUND

### 1. Field

A method and apparatus for protecting a precharge resistor provided in a battery pack is disclosed.

### 2. Description of the Related Art

Secondary batteries are batteries that can be charged and discharged, unlike primary batteries that cannot be recharged. Low-capacity secondary batteries are used for small electronic devices that can be carried, such as smartphones, feature phones, laptop computers, digital cameras and camcorders, and large-capacity secondary batteries are widely used as batteries for power supply for motor driving and batteries for power storage for hybrid cars, electric vehicles, etc. Such secondary batteries include an electrode assembly including an anode and a cathode, a case that accommodates the electrode assembly, and an electrode terminal connected to the electrode assembly.

### SUMMARY

Embodiments are directed to a method of protecting a precharge resistor provided in a battery pack, including attempting a first attempt to charge a precharge capacitor, the precharge capacitor being electrically connected to two ends of a battery module provided in the battery pack and charged by receiving a precharge current from the battery module, adding predetermined penalty points to a summed penalty point total based on a result of the first attempt to charge the precharge capacitor, determining whether the precharge resistor is in a limited state based on the summed penalty point total, and preventing a second attempt to charge the precharge capacitor for a predetermined time if the precharge resistor is in the limited state.

An implementation may include the first attempt to charge the precharge capacitor including allowing a precharge current to flow through a precharging path by closing a precharge relay provided in series with the precharge resistor on the precharging path electrically connected to one end of the battery module and one end of the precharge capacitor.

An implementation may include determining whether the precharge resistor may be in the limited state based on the summed penalty point total including adding a first predetermined point amount to the summed penalty point total if the precharge capacitor is charged for a preset normal time and a successful attempt to charge the precharge capacitor occurs.

An implementation may include determining whether the precharge resistor may be in the limited state based on the summed penalty point total including adding a second predetermined point amount to the summed penalty point total if a cancelled attempt to charge the precharge capacitor occurs.

An implementation may include determining whether the precharge resistor is in the limited state based on the summed penalty point total including adding a third, fourth, or fifth predetermined point amount to the summed penalty point total for each failure whenever precharging fails, by classifying cases where a failed attempt to charge the precharge capacitor occurs into three cases, a first case where precharging is performed for a longer time than the predetermined time, which may result in the third predetermined point amount being added to the summed penalty point total, a second case where precharging is performed for a shorter time than the predetermined time, which may result in the fourth predetermined point amount being added to the summed penalty point total, and a third case where the precharging path is short-circuited, which may result in the fifth predetermined point amount being added to the summed penalty point total.

An implementation may include determining whether the precharge resistor is in the limited state including determining that the precharge resistor may be in the limited state if both a failed reattempt to charge of the precharge capacitor occurs and the summed penalty point total satisfies a threshold level after charging of the precharge resistor fails.

An implementation may include preventing the second attempt to charge the precharge capacitor including operating a penalty timer for a predetermined time if the precharge resistor is in the limited state, and preventing the precharge relay from being closed while the penalty timer operates.

An implementation may include preventing the second attempt to charge the precharge capacitor including storing a remaining time in the penalty timer if there is time remaining in the penalty timer due to shut-down of the penalty timer before the timer is expired, and operating the penalty timer for the remaining time in a next cycle in which the penalty timer is waken up, to prevent the precharge relay from being closed while the penalty timer operates.

An implementation may include the processor allowing precharging to reattempt only after a predetermined reattempt time elapses, if the summed penalty point total does not satisfy the threshold level.

An implementation may include the predetermined reattempt time being 300 ms.

Embodiments are directed to an apparatus for protecting a precharge resistor provided in a battery pack, including a precharge capacitor electrically connected to two ends of a battery module provided in the battery pack and charged by receiving a precharge current from the battery module, and a processor, the processor being configured for: attempting a first attempt to charge the precharge capacitor, adding predetermined penalty points to a summed penalty point total based on a result of the first attempt to charge the precharge capacitor, determining whether the precharge resistor is in a limited state, and preventing a second attempt to charge the precharge capacitor for a predetermined time based on the summed penalty point total if the precharge resistor is in the limited state.

An implementation may include a precharge relay provided in series with the precharge resistor on a precharging path electrically connected to one end of the battery module and one end of the precharge capacitor, wherein the processor closes the precharge relay to allow the precharge current to flow through the precharging path.

An implementation may include the processor being configured for adding a first predetermined point amount to the summed penalty point total if the precharge capacitor is charged for a preset normal time and a successful attempt to charge the precharge capacitor occurs.

An implementation may include the processor being configured for adding a second predetermined point amount to the summed penalty point total if a cancelled attempt to charge the precharge capacitor occurs.

An implementation may include the processor being configured for adding a third, fourth, or fifth predetermined point amount to the summed penalty point total for each failure whenever precharging fails, by classifying cases where a failed attempt to charge the precharge capacitor occurs into three cases, a first case where precharging is performed for a longer time than the predetermined time, which may result in the third predetermined point amount being added to the summed penalty point total, a second case where precharging is performed for a shorter time than the predetermined time which may result in the fourth predetermined point amount being added to the summed penalty point total, and a third case where the precharging path is short-circuited which may result in the fifth predetermined point amount being added to the summed penalty point total.

An implementation may include the processor being configured for determining whether the precharge resistor is in the limited state, the determination may include both a reattempt to charge the precharge capacitor failing and the summed penalty point total satisfying a threshold level after the reattempt to charge the precharge capacitor fails.

An implementation may include the processor being configured for operating a penalty timer for a predetermined time if the precharge resistor is in the limited state and preventing the precharge relay from being closed while the penalty timer operates.

An implementation may include the processor being configured for storing any remaining time in the penalty timer due to shut-down of the penalty timer before a timer is expired, operating the penalty timer for the remaining time in a next cycle in which the penalty timer is waken up, and preventing the precharge relay from being closed while the penalty timer operates.

An implementation may include the processor being configured for allowing precharging to reattempt only after a predetermined reattempt time elapses, if the summed penalty point total does not satisfy the threshold level.

An implementation may include the predetermined reattempt time being 300 ms.

### BRIEF DESCRIPTION OF THE DRAWINGS

Features will become apparent to those of skill in the art by describing in detail exemplary embodiments with reference to the attached drawings in which:
FIG. 1 is a diagram showing an example apparatus for protecting a precharge resistor including an anode main relay, a cathode main relay, and a precharge relay between a processor and a battery pack voltage.
FIG. 2 is a flowchart showing an example method of protecting a precharge resistor by imposing a counter and a penalty timer on the precharging attempt.
FIG. 3 is a flowchart showing steps in an example method of imposing a penalty timer.
FIG. 4 is a diagram showing a method of protecting a precharge resistor by activating a diagnostic trouble code during a penalty timer.
FIG. 5 is a diagram showing a method of protecting a precharge resistor by activating a diagnostic trouble code during a penalty timer including pausing the penalty timer during a shutdown time.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," if preceding a list of elements, modify the entire list of elements and do not modify the individual elements of the list.

Hereinafter, embodiments of the present disclosure will be described in detail with reference to the accompanying drawings. Prior to this, the terms and words used in the specifications and claims should not be interpreted in a conventional or dictionary sense, and the inventor appropriately describes the concept of terms in embodiments in the best way. Based on the principle that it can be defined, it should be interpreted as the meaning and concept that meets the technical spirit of the present disclosure. Thus, the embodiments described herein and the configuration illustrated in the drawings are only the most desirable embodiments of the present disclosure, and not representing all of the technical spirits of the present disclosure, so that it should be understood that there may be various equivalents and modifications that can be replaced at the time of filing the present application. In addition, if the terms such as "comprise, include" and/or "comprising, including" are used herein, the terms specify the presence of mentioned forms, numbers, steps, movements, members, elements and/or of these groups and the terms do not exclude the presence or addition of one or more different shapes, numbers, actions, members, elements and /or groups. In addition, when describing embodiments of the present disclosure, "~ can be", "~ may be" may include "one or more embodiments of the present disclosure".

In addition, in order to help understanding of the present disclosure, the accompanying drawings are not shown according to the actual accumulation, but the dimensions of some components may be exaggerated. In addition, the same reference number may be given to the same elements in different embodiments.

The mention of two comparisons is 'the same' means 'substantially the same'. Thus, substantial same may include cases where deviations are considered low in the art, for example, within 5%. In addition, the uniform parameter in a certain area may mean that it is uniform from the average point of view.

Although the terms of the first and second, etc. are used for the description of various elements, these elements are not limited by these terms. These terms are used for the purpose of distinguishing one component from other components, and a first element may also be a second element unless there is a particularly opposite description.

Throughout the specification, unless there is a particularly opposite description, each element may be single or in plurality.

When an arbitrary element is disposed "above (or below)" or "on (or under)" another element, this is not only when the arbitrary element is disposed adjacent to an upper surface (or a lower surface) of the element, but also when other elements are interposed between the element and the arbitrary element disposed on (or under) the element.

In addition, if an element is "connected", "coupled" or "linked" to other elements, it should be understood that this is not only if these elements are directly connected or linked to each other but also if other elements are "interposed" between the elements or each element may also be "connected", "coupled" or "linked" to each other through another element. In addition, if a portion is electrically connected to other portions, this is not only if the portion is directly connected to other portions, but also if other elements are interposed therebetween.

Through the specification, when it is called "A and/or B", unless there is a particularly opposite description, this means A, B, or A and B. That is, "and/or" include all combinations or any combinations of plurality of items listed. When it is called "C to D", unless there is a particularly opposite description, this means that it is C or more and D or less.

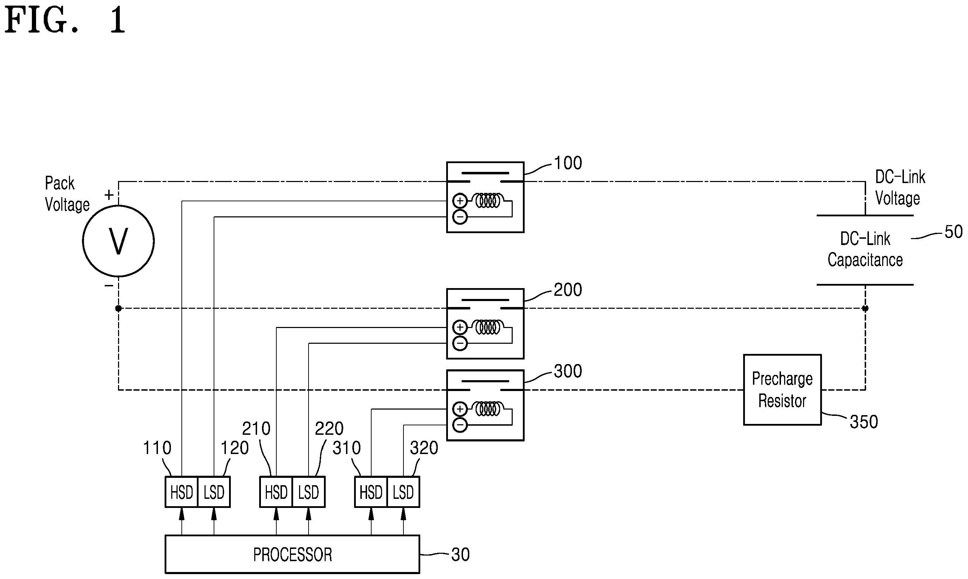

FIG. 1 is a diagram showing an example apparatus for protecting a precharge resistor including an anode main relay, a cathode main relay, and a precharge relay between a processor and a battery pack voltage. Referring to FIG. 1, the apparatus for protecting the precharge resistor may be provided in a battery pack. The apparatus for protecting the precharge resistor may include a battery module V, a precharge resistor 350, a precharge capacitor 50, and a processor 30. The apparatus for protecting the precharge resistor may include a precharge relay 300, an anode main relay 100, and a cathode main relay 200. The apparatus for protecting the precharge resistor may include relay drivers 110 and 120 for controlling the precharge relay 300, relay drivers 210 and 220 for controlling the anode main relay 100, and relay drivers 310 and 320 for controlling the cathode main relay 200.

An example battery pack may include at least one battery module V and a pack housing having an accommodation space in which the at least one battery module V is accommodated. The battery module V may include a plurality of battery cells and a module housing. The plurality of battery cells may be accommodated in the module housing in a stacked form. Each of the battery cells may include an anode lead and a cathode lead. The battery cells may be circular type battery cells, square type battery cells or pouch type battery cells according to a battery type. In the battery pack, one cell stack stacked instead of the battery module may constitute one module. The cell stack may be accommodated in the accommodation space of the pack housing or may be accommodated in the accommodation space partitioned by frames or barrier walls.

The battery module V may include at least one battery cell, and the battery cell may be a secondary battery that may be charged. In an implementation, the battery cell may include a nickelcadmium battery, a lead battery, a nickel metal hydride battery (NiMH), a lithium ion battery, or a lithium polymer battery. As used herein, the term "or" is not an exclusive term, e.g., "A or B" would include A, B, or A and B.

The number of battery cells included in the battery module V and a connecting method thereof may be determined based on the amount of power and voltage required for the battery pack. The battery cells provided in the battery module V may be connected in parallel or may be connected in series and parallel. FIG. 1 shows that a battery pack includes one battery module V. In an implementation, the battery pack may include a plurality of battery modules V connected in series, in parallel, or in series and parallel. The battery module V may also include only one battery cell.

The battery module V may include a plurality of battery modules each including a plurality of battery cells. The battery pack may include a pair of pack terminals to which an electric load or a charge device may be connected.

The apparatus for protecting the precharge resistor may charge the precharge capacitor 50. In an implementation, the apparatus for protecting the precharge resistor may charge the precharge capacitor 50 electrically connected to two ends of the battery module V including a plurality of secondary batteries. In an implementation, as shown in the configuration of FIG. 1, two ends of the precharge capacitor 50 may be electrically connected to an anode of the battery module V and a cathode of the battery module V, respectively.

The apparatus for protecting the precharge resistor may include a precharging path. The precharging path may transmit a precharge current to the precharge capacitor 50. In an implementation, the precharging path may receive the precharge current from the battery module V and transmit the precharge current to the precharge capacitor 50. In an implementation, the precharging path may include an electric circuit that electrically connects between one end of the battery module V and one end of the precharge capacitor 50. In an implementation, the precharge capacitor 50 may be electrically connected to both ends of the battery module V provided in the battery pack and may be charged by receiving the precharge current from the battery module V.

In an implementation, as shown in FIG. 1, the precharging path may include the precharge relay 300 and the precharge resistor 350. The precharge relay 300 and the precharge resistor 350 may be electrically provided in series on the precharging path. In an implementation, as shown in FIG. 1, the precharging path may be electrically connected in parallel with a main charging/discharging path. The main charging/discharging path may include the cathode main relay 200. In an implementation, the precharge relay 300 may be provided in series with the precharge resistor 350 on the precharging path electrically connected to one end of the battery module V and one end of the precharge capacitor 50.

The precharge relay 300 may open/close the precharging path through which the precharge current flows. The precharge relay 300 may be a switch for opening/closing the precharging path. In an implementation, the precharge relay 300 may open/close the precharging path through turn-on and turn-off operations. In an implementation, the precharge relay 300 may be implemented with a mechanical relay or semiconductor relay. The precharge resistor 350 may be electrically in series connected to the precharge relay 300. In an implementation, the precharge resistor 350 may be connected in series with the precharge relay 300 on the precharging path.

The main charging/discharging path may include the anode main relay 100 and the cathode main relay 200 on the main charging/discharging path. The main charging/discharging path may be a path, which may be electrically connected to one end of the battery module V and through which a charging/discharging current may flow. In an implementation, as shown in the configuration of FIG. 1, the main charging/discharging path may be between one end of the battery module V and one end of the precharge capacitor 50. The anode main relay 100 and the cathode main relay 200 may be switches for opening/closing the main charging/discharging path. In an implementation, the anode main relay 100 and the cathode main relay 200 may open/close the main charging/discharging path through turn-on and turn-off operations. In an implementation, the anode main relay 100 and the cathode main relay 200 may be implemented with a mechanical relay or semiconductor relay.

The apparatus for protecting the precharge resistor may include a processor 30 and memory. The processor 30 may control the overall operation of the apparatus for protecting the precharge resistor. In an implementation, the processor 30 may include application-specific integrated circuits (ASICs), other chipsets, logical circuits, registers, communication modems and/or data processing devices, so as to perform the above-described operations. The processor 30 may perform basic arithmetic, logic and input/output operations, and may execute program codes stored in memory. The processor 30 may store data in the memory or may load the data stored in the memory.

The memory may be a recording medium that may be read by the processor 30, and may include a permanent mass storage device such as read access memory (RAM), read only memory (ROM), or a disc drive. An operating system and at least one program or application code may be stored in the memory.

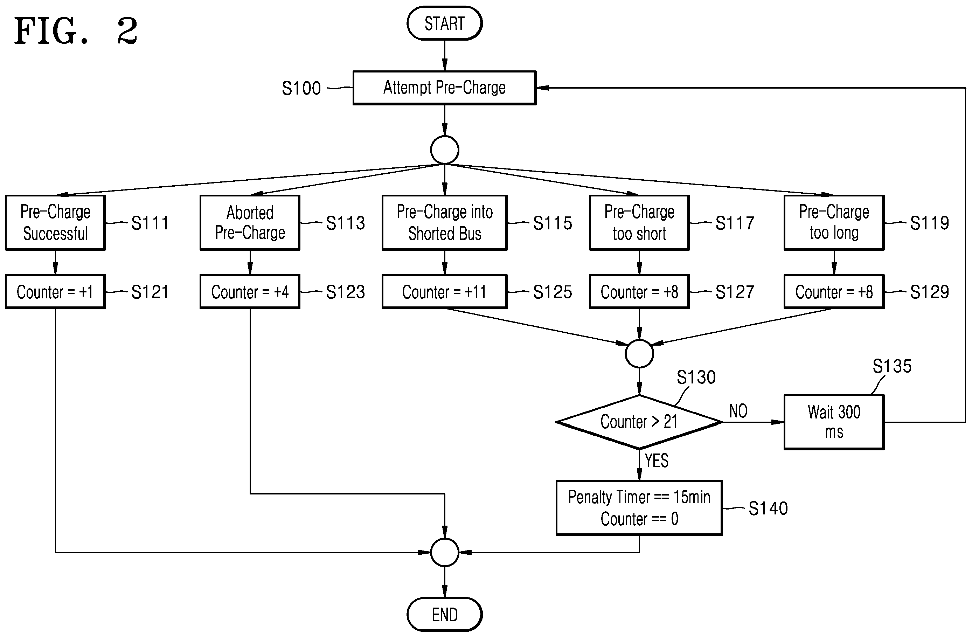

FIG. 2 is a flowchart showing an example method of protecting a precharge resistor by imposing a counter and a penalty timer on the precharging attempt. The method of protecting the precharge resistor may be performed by the processor 30 shown in FIG. 1.

Referring to FIGS. 1 and 2 together, in operation S100, the processor 30 may be electrically connected to both ends of the battery module V provided in the battery pack and may attempt to charge the precharge capacitor 50 by receiving a precharge current from the battery module V. In an implementation, the processor 30 may attempt to charge the precharge capacitor 50 by closing the precharge relay 300 before closing the cathode main relay 200 of the battery pack.

The processor 30 may allow the precharge current to flow through the precharging path by closing the precharge relay 300 provided in series with the precharge resistor 350 on the precharging path electrically connected to one end of the battery module V and one end of the precharge capacitor 50.

Subsequently, the processor 30 may count a predetermined penalty point imposed on the result of an attempt to charging of the precharge capacitor 50, thereby determining whether the precharge resistor 350 is in a limited state, based on the penalty point.

In operation S111, the processor 30 may count a predetermined point for success, if the precharge capacitor 50 is charged for a preset normal time and an attempt to charging of the precharge capacitor 50 is successful. In an implementation, in operation S121, the processor 30 may count one point for success, if an attempt to charging of the precharge capacitor 50 is successful.

In operation S113, the processor 30 may count a predetermined point for cancellation, if an attempt to charging of the precharge capacitor 50 is cancelled. In an implementation, in operation S123, the processor 30 may count four points for cancellation, if an attempt to charging of the precharge capacitor 50 is cancelled.

In operation S115, operation S117, and operation S119, the processor 30 may count a predetermined point for each failure whenever precharging fails, by classifying cases where an attempt to charging of the precharge capacitor 50 fails, into three cases, the case where precharging is performed for a longer time than a predetermined time (S115), the case where precharging is performed for a shorter time than the predetermined time (S117), and the case where a precharging path is short-circuited (S119). In an implementation, in operation S125, the processor 30 may count 11 points for failure, if precharging is performed for a longer time than a predetermined time (e.g., 500 ms). In operation S127, the processor 30 may count 8 points for failure, if precharging is performed for a shorter time than a predetermined time (e.g., 500 ms). In operation S129, the processor 30 may count 8 points for failure if the precharging path is short-circuited (e.g., if the precharging path is short-circuited with a car).

Subsequently, in operation S130, the processor 30 may determine that the precharge resistor 350 is in a limited state, if a reattempt to charging of the precharge capacitor 50 fails, after charging of the precharge capacitor 50 fails and a summed penalty point is greater than or equal to a predetermined penalty point. In an implementation, the processor 30 may determine that the precharge resistor 350 is in a limited state, if a reattempt to charging of the precharge capacitor 50 fails and a summed penalty point is greater than or equal to 21 points. In an implementation, the processor 30 may allow precharging to reattempt after the predetermined time (e.g., 300 ms) elapses, if a reattempt to charging of the precharge capacitor 50 fails and a summed penalty point is less than 21 points.

Subsequently, in operation S140, the processor 30 may prevent an attempt to charging of the precharge capacitor 50 for a pre-determined time (e.g., 15 minutes), if the precharge resistor 350 is in a limited state. In an implementation, the processor 30 may operate a penalty timer for the predetermined time, if the precharge resistor 350 is in a limited state. Also, the processor 30 may prevent the precharge relay 300 from being closed while the penalty timer operates.

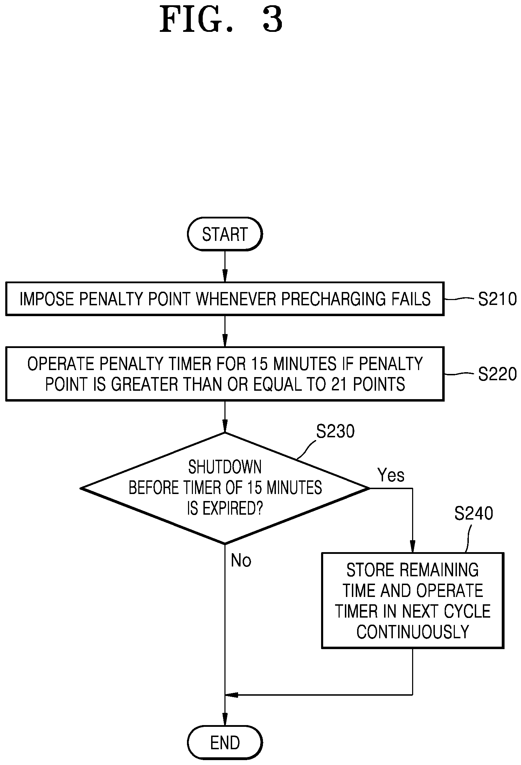

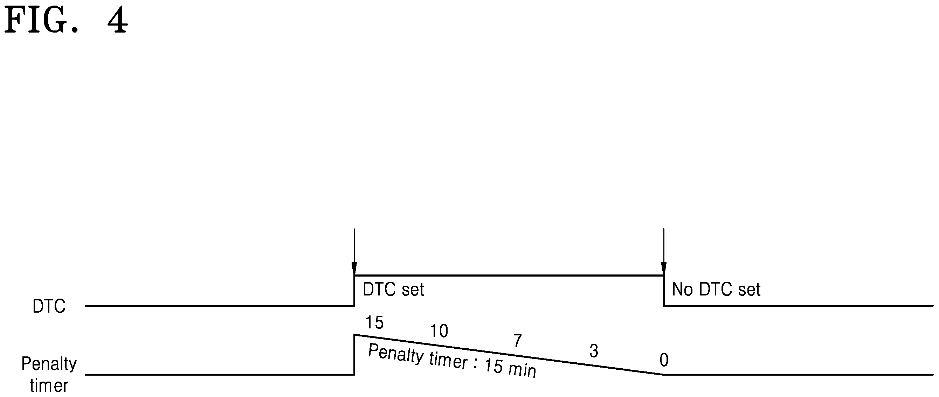

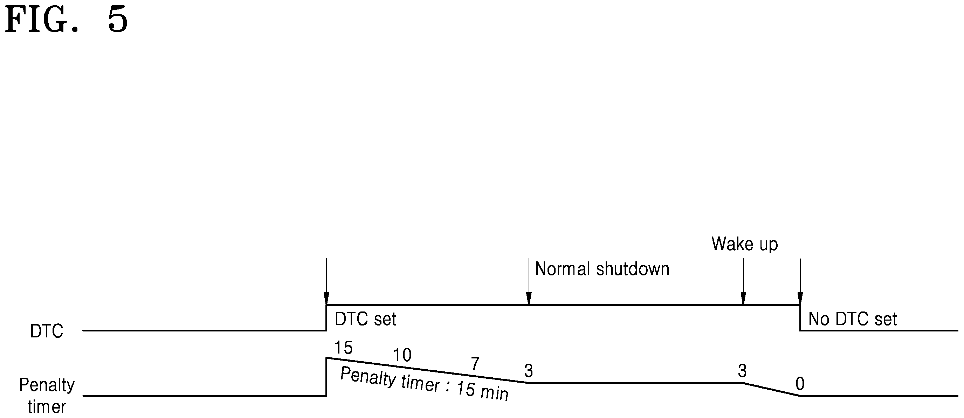

FIG. 3 is a flowchart showing steps in an example method of imposing a penalty timer. FIG. 4 is a diagram showing a method of protecting a precharge resistor by activating a diagnostic trouble code during a penalty timer. FIG. 5 is a diagram showing a method of protecting a precharge resistor by activating a diagnostic trouble code during a penalty timer including pausing the penalty timer during a shutdown time.

First, referring to FIG. 3, in operation S210, the processor 30 may count a predetermined point for each failure whenever precharging fails, by classifying cases where an attempt to charging of the precharge capacitor 50 fails, into three cases, the case where precharging is performed for a longer time than a predetermined time, the case where precharging is performed for a shorter time than the predetermined time, and the case where a precharging path is short-circuited. In an implementation, the processor 30 may count 11 points for failure, if precharging is performed for a longer time than the predetermined time (e.g., 500 ms). The processor 30 may count 8 points for failure, if precharging is performed for a longer time than the predetermined time (e.g., 500 ms). The processor 30 may count 8 points for failure, if the precharging path is short-circuited (e.g., if the precharging path is short-circuited with a car).

In operation S220, the processor 30 may determine that the precharge resistor 350 is in a limited state, if a reattempt to charging of the precharge capacitor 50 fails and a summed penalty point is greater than or equal to 21 points. The processor 30 may prevent an attempt to charging of the precharge capacitor 50 for a pre-determined time (e.g., 15 minutes), if the precharge resistor 350 is in a limited state, thereby operating a penalty timer.

In an implementation, referring to FIG. 4, if the penalty timer operates for 15 minutes, a diagnostic trouble code (DTC) may be set, 900 seconds (15 minutes) may be stored in the memory, and the precharge resistor 350 may be stopped, and the temperature may be lowered until 0 seconds is reached.

In operations S230 and S240, the processor 30 may store the remaining time in the penalty timer, if there is time remaining in the penalty timer due to shut-down of the penalty timer, before the timer is expired for a predetermined time of the penalty timer. Also, the processor 30 may operate the penalty timer for the remaining time in a next cycle in which the penalty timer is waken up and may prevent the precharge relay 300 from being closed while the penalty timer operates. In an implementation, referring to FIG. 5 together, if shut-down (e.g., 12 V battery discharge, BPCM reset etc.) occurs before the penalty timer of 15 minutes is expired, the remaining time of 3 minutes may be stored in the memory so that the timer of the remaining time of 3 minutes may be expired in a next cycle. In some embodiments, a 15-minute break may be ensured so that damage of the precharge resistor may be prevented.

By way of summation and review, a battery pack including the secondary battery may include a main relay on a charging/discharging path. In addition, precharging may be attempted to close the main relay for the use of the battery pack, and a precharge resistor may be damaged if precharging fails and is re-attempted several times. In the precharge resistor, the more the number of times of being precharged, the higher the temperature, and in this case, the precharge resistor is damaged and cannot be used. Thus, it is desirable to prevent the precharge resistor from being damaged due to the failure of precharging.

Various embodiments described above may be implemented in the form of a computer program that can be executed through various components on the computer, and such a computer program may be recorded in a computer-readable medium. At this time, the medium may be to keep storing or executing programs that can be executable on a computer or to be temporarily stored for execution or download. The medium may be a variety of recording units or storage units of a single or several hardware, which may be dispersed on a network, not limited to the medium directly connected to any computer system. An example of the medium may include a medium having program instruction languages stored therein including a magnetic medium such as a hard disk, a floppy disk and a magnetic tape, a photovoltaic medium such as CD-ROM and DVD, a magnetooptical medium such as a floptical disk, ROM, RAM, flash memory, etc. An example of other mediums may also include a recording medium or storage medium managed by an application store that distributes applications or other sites that supply or distribute various software.

In the present specification, a "unit", "module", etc. may be a hardware component such as a processor or a circuit and/or a software component executed by the hardware component such as the processor. For example, a "unit" and "module", etc. may be implemented by components such as software components, object-oriented software components, class components and task components, processes, functions, properties, attributes, procedures, sub-routines, segments of program codes, drivers, firmware, microcodes, circuits, data, databases, data structures, tables, arrays and variables.

In an embodiment, damage of a precharge resistor can be efficiently prevented.

However, the effects that can be obtained by the present disclosure are not limited to the above-described effects, and other unmentioned effects can be clearly understood to those skilled in the art from the description of the present disclosure described below.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope of the present disclosure as defined by the following claims.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A method of protecting a precharge resistor (350) provided in a battery pack, the method comprising:
attempting (S100) a first attempt to charge a precharge capacitor (50), the precharge capacitor (50) being electrically connected to two ends of a battery module (V) provided in the battery pack and charged by receiving a precharge current from the battery module (V);
adding (S121, S123, S125, S127, S129) predetermined penalty points to a summed penalty point total based on a result (S111, S113, S115, S117, S119) of the first attempt to charge the precharge capacitor (50);
determining (S130) whether the precharge resistor (350) is in a limited state based on the summed penalty point total; and
preventing (S135) a second attempt to charge the precharge capacitor (50) for a predetermined time if the precharge resistor (350) is in the limited state.

2. The method according to claim 1, wherein the first attempt to charge the precharge capacitor (50) includes allowing a precharge current to flow through a precharging path by closing a precharge relay (300) provided in series with the precharge resistor (350) on the precharging path electrically connected to one end of the battery module (V) and one of the two ends of the precharge capacitor (50).

3. The method according to claim 1 or 2, wherein determining whether the precharge resistor (350) is in the limited state based on the summed penalty point total includes adding a first predetermined point amount to the summed penalty point total (S121) if the precharge capacitor (50) is charged for a preset normal time and a successful attempt to charge the precharge capacitor (50) occurs (S111).

4. The method according to any one of claims 1 to 3, wherein determining whether the precharge resistor (350) is in the limited state based on the summed penalty point total includes adding a second predetermined point amount to the summed penalty point total (S123) if a cancelled attempt to charge the precharge capacitor occurs (113).

5. The method according to any one of claims 1 to 4, wherein determining whether the precharge resistor (350) is in the limited state based on the summed penalty point total includes adding a third, fourth, or fifth predetermined point amount to the summed penalty point total (S129, S127, S125) for each failure whenever precharging fails, by classifying cases where a failed attempt to charge the precharge capacitor (50) occurs into three cases, a first case where precharging is performed for a longer time than the predetermined time (S119), resulting in the third predetermined point amount being added to the summed penalty point total (129), a second case where precharging is performed for a shorter time than the predetermined time (117), resulting in the fourth predetermined point amount being added to the summed penalty point total (S127), and a third case where the precharging path is short-circuited (S115), resulting in the fifth predetermined point amount being added to the summed penalty point total (S125).

6. The method according to any one of claims 1 to 5, wherein determining whether the precharge resistor (350) is in the limited state includes determining that the precharge resistor (350) is in the limited state if both a failed reattempt to charge of the precharge capacitor (50) occurs (S210) and the summed penalty point total satisfies a threshold level (S220) after charging of the precharge resistor (350) fails.

7. The method according to claim 2 or any one of claims 3 to 6, as far as dependent on claim 2, wherein preventing the second attempt to charge the precharge capacitor (50) includes:
operating a penalty timer for a predetermined time if the precharge resistor (350) is in the limited state; and
preventing the precharge relay (300) from being closed while the penalty timer operates.

8. The method according to claim 7, wherein preventing the second attempt to charge the precharge capacitor (50) includes:
storing a remaining time in the penalty timer if there is time remaining in the penalty timer due to shut-down of the penalty timer before the timer is expired (S230); and
operating the penalty timer for the remaining time in a next cycle in which the penalty timer is waken up, to prevent the precharge relay (300) from being closed while the penalty timer operates.

9. The method according to claim 6 or, as far as depending on claim 6, claim 7 or 8, wherein a processor (30) allows precharging to reattempt only after a predetermined reattempt time elapses, if the summed penalty point total does not satisfy the threshold level.

10. The method according to claim 9, wherein the predetermined reattempt time is 300 ms.

11. An apparatus for protecting a precharge resistor (350) provided in a battery pack, comprising:
a precharge capacitor (50) electrically connected to two ends of a battery module (V) provided in the battery pack and charged by receiving a precharge current from the battery module (V); and
a processor (30), the processor (30) being configured for:
attempting (S100) a first attempt to charge the precharge capacitor (50),
adding (S121, S123, S125, S127, S129) predetermined penalty points to a summed penalty point total based on a result (S111, S113, S115, S117, S119) of the first attempt to charge the precharge capacitor (50),
determining (S130) whether the precharge resistor (350) is in a limited state, and
preventing (S135) a second attempt to charge the precharge capacitor (50) for a predetermined time based on the summed penalty point total if the precharge resistor (350) is in the limited state.

12. The apparatus according to claim 11, further comprising a precharge relay (300) provided in series with the precharge resistor (350) on a precharging path electrically connected to one end of the battery module (V) and one of the two ends of the precharge capacitor (50), wherein the processor (30) closes the precharge relay (300) to allow the precharge current to flow through the precharging path.

13. The apparatus according to claim 11 or 12, wherein the processor (30) is configured to add a first predetermined point amount to the summed penalty point total (S121) if the precharge capacitor (50) is charged for a preset normal time and a successful attempt to charge the precharge capacitor (50) occurs (S111).

14. The apparatus according to any one of claims 11 to 13, wherein the processor (30) is configured to add a second predetermined point amount to the summed penalty point total (S123) if a cancelled attempt to charge the precharge capacitor (50) occurs (S113).

15. The apparatus according to any one of claims 11 to 14, wherein the processor (30) is configured to add a third, fourth, or fifth predetermined point amount to the summed penalty point total (S129, S127, S125) for each failure whenever precharging fails, by classifying cases where a failed attempt to charge the precharge capacitor (50) occurs into three cases, a first case where precharging is performed for a longer time than the predetermined time (S119), resulting in the third predetermined point amount being added to the summed penalty point total (S129), a second case where precharging is performed for a shorter time than the predetermined time (S117), resulting in the fourth predetermined point amount being added to the summed penalty point total (S127), and a third case where the precharging path is short-circuited (S115), resulting in the fifth predetermined point amount being added to the summed penalty point total (S125).
